# EUROPÄISCHE PATENTSCHRIFT

(11) **EP 3 353 817 B1**
(45) Veröffentlichungstag und Bekanntmachung des Hinweises auf die Patenterteilung: **10.06.2020**
(21) Anmeldenummer: 16798621.5
(22) Anmeldetag: 17.09.2016
(51) Int. Cl.: H01L 31/0525, H01L 31/0352

(54) **NANORÖHRENTHERMOGENERATOR-PHASENWECHSELSPEICHER NRTHGPWS**
NANOTUBE THERMOELECTRIC GENERATOR LATENT-HEAT STORAGE CELL (NRTHGPWS)
ACCUMULATEUR À CHANGEMENT DE PHASE POUR THERMOGÉNÉRATEUR À NANOTUBES NRTHGPWS

(30) Priorität: 24.09.2015 DE 102015012405
(43) Veröffentlichungstag der Anmeldung: 01.08.2018
(73) Patentinhaber: Hammer, Roland, 18182 Mönchhagen (DE); Kleber, Joachim, 65428 Rüsselsheim (DE)
(72) Erfinder: Hammer, Roland, 18182 Mönchhagen (DE); Kleber, Joachim, 65428 Rüsselsheim (DE)
(74) Vertreter: Baumbach, Friedrich
(86) Internationale Anmeldenummer: PCT/DE2016/000347
(87) Internationale Veröffentlichungsnummer: WO 2017/050308

(56) Entgegenhaltungen:
- EP-A2- 2 660 880
- EP-B1- 2 606 512
- DE-A1-102010 035 384
- JP-A- 2007 115 806
- KR-A- 20060 054 760
- US-A1- 2007 012 354
- US-A1- 2013 193 404
- US-A1- 2014 041 705
- US-A1- 2015 243 820
- LEE JI: "Photovoltaic effect in ideal carbon nanotube diodes", APPLIED PHYSICS LETTERS, A I P PUBLISHING LLC, US, Bd. 87, Nr. 7, 8. August 2005 (2005-08-08) , Seiten 73101-073101, XP012077487, ISSN: 0003-6951, DOI: 10.1063/1.2010598
- TSAKALAKOS ET AL: "Nanostructures for photovoltaics", MATERIALS SCIENCE AND ENGINEERING: R: REPORTS, ELSEVIER, AMSTERDAM, NL, Bd. 62, Nr. 6, 10. November 2008 (2008-11-10), Seiten 175-189, XP025627217, ISSN: 0927-796X, DOI: 10.1016/J.MSER.2008.06.002 [gefunden am 2008-08-15]

## Beschreibung

### Beschreibung der Erfindung

Die Erfindung betrifft eine Anlage zur Wandlung von Energie aus Strahlung unterschiedlicher Wellenlänge in elektrische Energie.

Anwendungsgebiete der Erfindung sind die Gewinnung von elektrischer Energie aus solarer Strahlung, die Gewinnung elektrischer Energie aus Abwärmeprozessen sowie die aktive Bauteilkühlung, wie beispielsweise die Klimatisierung umbauter Räume durch Gewinnung elektrischer Energie.

In der Beschreibung werden folgende Abkürzungen verwendet:
- NRTHGPWS-Zelle:: Nanoröhrenthermogenerator-Phasenwechselspeicher-Zelle

### Stand der Technik

Die Nutzbarmachung der Sonnenenergie ist seit vielen Jahren Gegenstand intensiver Forschung. Bei der aktiven Nutzung der Sonnenenergie stehen dabei zwei Ansätze im Fokus. So kann Sonnenenergie zum einen mithilfe der Solarthermie zur Gewinnung von Wärme, zum anderen aber auch mittels der Photovoltaik zur Gewinnung von Strom genutzt werden. Mittlerweile stehen zahlreiche solarthermische oder photovoltaische Anlagen mit entsprechenden Speicher- und Nutzungsmöglichkeiten zur Verfügung.

Mithilfe von Sonnenkollektoren solarthermischer Anlagen werden die Sonnenstrahlen in Wärme umgewandelt und für die spätere Nutzung gespeichert.

Bisherige Systeme zur Wandlung von Strahlungsenergie in elektrische Energie sind vor allem in der Photovoltaik weit verbreitet, wobei hier die Umwandlung mithilfe von Solarzellen stattfindet.

In den letzten 10 Jahren konnte die Photovoltaik im Hinblick auf die Energieversorgung immer mehr an Bedeutung gewinnen. So deckte im Jahr 2014 die Photovoltaik ca. 6,9% des Netto-Stromverbrauchs in Deutschland ab (vorläufige Schätzung des BDEW). Alle erneuerbaren Energien kamen dabei zusammen auf 31%. Die Photovoltaik liefert damit einen stetig wachsenden Beitrag zur Stromversorgung und ist ein wichtiger Eckpfeiler in der Umsetzung der Ziele in der Energiewende.

Photovoltaik-Module weisen in der Regel eine Schicht aus Solar- bzw. Photovoltaikzellen auf, sowie eine auf der Sonnenseite der Photovoltaikzellen angeordnete transparente Folie und ein auf der Folie angeordnetes transparentes Sicherheitsglas. Auf der Rückseite der Photovoltaikzellen, d.h. auf der Sonnen abgewandten Seite der Zellen, ist üblicherweise ebenfalls eine Folienschicht aufgebracht.

Die Wirkungsweise einer solchen Zelle beruht auf dem hinreichend bekannten photovoltaischen Effekt. Dieser ist Stand der Technik und wird in zahlreichen Schriften beschrieben (z.B. DE 21 2009 000 025 U1, WO 2009/135238 A2). Bei Lichteinwirkung findet in der Zelle an dem Halbleiterübergang eine Ladungstrennung statt, der zu einem Ladungsungleichgewicht in der Zelle führt. Das dabei entstehende elektrische Spannungsgefälle kann zur Umwandlung der Strahlungsenergie in elektrische Energie genutzt werden. Die Ladungstrennung findet in der Zelle über die Fläche der Zelle statt. Im idealisierten Modell erstrecken sich der positive und negative Pol über die gesamte Fläche, je nach Stoffpaarung liegt der positive Pol auf der vorderen und der negative Pol auf der hinteren Seite oder umgekehrt. Dies geht aus dem Ort der Ladungstrennung hervor. Rückseitenkontaktierte Zellen beruhen meist auf dem Umstand, dass Zellbereiche entfernt werden und der vordere Bereich leitend nach hinten geführt ist.

Der Wirkungsgrad einer Photovoltaikanlage, auch als Effizienz bezeichnet, ist das Verhältnis der von ihr erzeugten elektrischen Leistung und der eingestrahlten Sonnenenergie. Das heißt, sie gibt an, wie viel der eingestrahlten solaren Strahlung in nutzbare elektrische Energie umgewandelt wird.

Das Einsatzgebiet der Photovoltaikanlagen bringt es mit sich, dass diese sich auf Grund der Sonneneinstrahlung erwärmen. Die Leistung einer solchen Anlage ist aber stark temperaturabhängig. Höhere Zelltemperaturen führen zu niedrigeren Leistungen und damit zu einem schlechteren Wirkungsgrad. Daraus resultiert ein großer Nachteil herkömmlicher Anlagen.

EP 2 606 512 B1 beschreibt eine Photovoltaikanlage, bei der auf der sonnenabgewandten Seite ein Modul über eine Wärmeleitpaste in Kontakt gebracht worden ist. Dieses Modul besteht aus mindestens einem Peltierelement mit jeweils nachgeordnetem Latentwärmespeicher, umgeben von einer Isolationsschicht. Dies ermöglicht eine Temperaturstabilisierung der sonnenabgewandten Seite einer Photovoltaikzelle, die der normierten Temperatur unter Laborbedingungen entspricht und verringert damit eine Leistungsminderung bei Temperaturanstieg. Darüber hinaus können die daraus resultierenden Wärmedifferenzen zur Erzeugung von elektrischer Energie genutzt werden.

Allerdings ist allen anderen bisher beschriebenen Photovoltaikanlagen gemeinsam, dass die Stromerzeugung dieser Anlagen nur auf den sichtbaren Bereich der Sonnenstrahlung beschränkt ist. So bleiben beispielsweise der UV- sowie der Infrarot-Bereich der Sonnenstrahlung mit herkömmlichen Anlagen, die auf die Umwandlung von solarer Strahlung in elektrische Energie zielen, völlig ungenutzt.

EP 2 606 512 B1 kommt zu dem Schluss, dass die spezifische Leistung gegenüber herkömmlichen Anlagen mindestens verdreifacht wird, theoretisch auch verzehnfacht werden kann. Vergleicht man das Strahlungsangebot der Sonne mit den terrestrisch elektrisch umgesetzten Leistungen und berücksichtigt den Umstand, dass die nicht umgesetzte Leistung auf der Erde von der Natur in diverse Wärmespeicher abgeben wird, die wiederum nach Erreichen Ihrer Kapazität ein Überangebot an die Umgebung in Form von Konvektion und Strahlung abgeben, so kommt man zu dem Schluss, dass für ein System, welches gesteuert aus Temperaturunterschieden elektrische Energie generiert nahezu unbegrenzt viel Primärenergie bereit steht. Für solch einen Vergleich steht die solare Strahlungskonstante zur Verfügung, deren Wert mit zwischen 1325 und 1420 Watt pro m² gemessen werden konnte. Der offizielle Mittelwert liegt bei 1367W/m². Vergleicht man diesen Mittelwert mit dem Spitzenwert von 122 W/m² (200 Wp pro 1,63 m²) eines handelsüblichen Solarmoduls so ergibt sich derzeit eine unmittelbare Ausbeute von 8,93 % und somit eine Verlustrate von 91 %. Das heißt 91% der eingestrahlten Leistung wird auf der Erde in Wärme umgesetzt und eingelagert bzw. verbleibt in der Atmosphäre oder wird ins All zurückgestrahlt. Diese hohe Verlustrate ist in der Fachwelt bekannt und stellt einen großen Nachteil bisher bekannter Vorrichtungen dar.

Ein weiterer Nachteil des Stands der Technik ist der Umstand, dass die Stromerzeugung nur bei direkter, unmittelbarer Sonneneinstrahlung - d.h. nur tagsüber erfolgt.

### Ziel und Aufgabe der Erfindung

Somit besteht die Aufgabe der Erfindung eine effiziente Vorrichtung bereitzustellen, die herkömmliche uneffektive Photovoltaikmodule ersetzt und mit der das gesamte Strahlungsspektrum der Sonneneinstrahlung aber auch anderweitige Strahlung, wie beispielsweise Wärmestrahlung, die nicht der direkten solaren Strahlung entstammt, zur Erzeugung elektrischer Energie genutzt werden kann. Darüber hinaus soll eine Vorrichtung bereitgestellt werden, die eine kontinuierliche Stromerzeugung - Tag und Nacht - gewährleistet.

Die Aufgabe wird durch die Vorrichtung gemäß Anspruch 1 gelöst. Weitere mögliche Ausführungsformen ergeben sich aus den Unteransprüchen, der Beschreibung, den Zeichnungen und den Beispielen.

### Wesen der Erfindung

Es hat sich überraschend herausgestellt, dass die Aufgabe durch eine erfindungsgemäße Nanoröhrenthermogenerator-Phasenwechselspeicher-Zelle (NRTHGPWS-Zelle) gelöst werden kann.

Die erfindungsgemäße NRTHGPWS-Zelle zur Erzeugung elektrischer Energie aus Strahlung ist dadurch gekennzeichnet, dass sie eine Nanoröhrenschicht, die bei Auftreffen von Strahlung unabhängig von der Wellenlänge in jedem Strahlungsbereich freie Elektronen freisetzt, beschaltet mit einer Vorrichtung zur Ladungstrennung, einem Nanoröhrenträger mit einseitiger elektrischer Kontaktierung, einem Modul zur Temperaturstabilisierung, bestehend aus mindestens einem Seebeck-Element, einem jeweils nachgeordneten Latentwärmespeicher und einer mehrseitig umfassenden Isolationsschicht besteht.

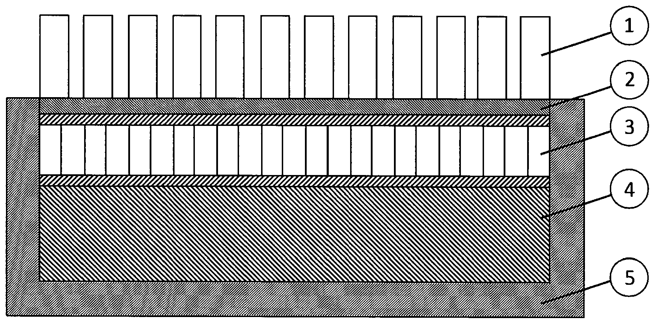

In einer bevorzugten Ausführungsform (Abb. 1) umfasst die erfindungsgemäße NRTHGPWS-Zelle eine Nanoröhrenschicht vorzugsweise bestehend aus Graphen, einen Nanoröhrenträger vorzugsweise ein Siliziumträger mit Siliziumnitridschicht und einseitiger elektrischer Kontaktierung, einem nachgeschalteten Thermogenerator als Seebeck-Element, einem Phasenwechselspeicher, der als Latentwärmespeicher fungiert und einer thermisch elektrischen Isolierung.

In einer weiteren bevorzugten Ausführungsform besteht die Nanoröhrenschicht aus einlagigen Graphenschichten.

Die Elektronenfreisetzung kann bei offener Bauweise der Nanoröhren aber auch bei geschlossener Bauweise erfolgen.

Nanoröhren sind mikroskopisch kleine, röhrenförmige Gebilde, deren Wände beispielsweise aus der Kohlenstoffatom Anordnung Graphen gebildet werden können. Sie werden in diesem Fall auch als Kohlenstoffnanoröhren bezeichnet. Dabei bilden die Kohlenstoffatome eine wabenartige Struktur mit Sechsecken und jeweils drei Bindungspartnern. Kohlenstoffnanoröhren zeichnen sich durch eine hohe Strombelastbarkeit und Wärmeleitfähigkeit aus.

In der Photovoltaik findet die Ladungstrennung in der Fläche und nicht extern statt, da jede einzelne Zelle eine Diode benötigt. Bisher wurden Nanoschichten zum Ersatz der transparent leitfähigen Schichten vorwiegend in Dünnschichtsolarzellen untersucht. Da in der Photovoltaik die Zellprozessierung sehr investitionsintensiv ist, scheut man sich hier bestehende Prozesse in Frage zu stellen, bevor die betroffenen Prozesse amortisiert sind.

### Wirkungsweise der NRTHGPWS-Zelle

Strahlung (zum Beispiel solare Strahlung, oder auch Wärmestrahlung anderer Quellen), die auf die Flächen der Nanoröhren auftrifft, wird von der Nanoröhrenschicht absorbiert, und erzeugt an ihrer Oberfläche freie Elektronen.

Diese freien Elektronen entladen sich an der elektrischen Anschlussmöglichkeit der Nanoröhrenschicht, wenn an dieser eine Diode zur Ladungstrennung und ein elektrischer Verbraucher mit einer Rückführung zur Nanoröhrenschicht angeschlossen ist (äußere Beschaltung).

Überschüssige (nicht abgeführte) Elektronen rekombinieren und erhitzen die Schicht aus Nanoröhren, so dass diese überschüssige Wärme abstrahlt. Wärmeübergänge richten sich naturgegeben von der Quelle zur Senke. Eine geeignete Randisolierung der Schichten verhindert die radiale Konvektion. Somit bleiben nur noch Wärmeübergänge vorwiegend in Form von Strahlung in die Schicht hinein bzw. aus der Schicht heraus.

Von der Strahlungsquelle weg folgt der Nanoröhrenschicht und dem Nanoröhrenträger eine Schicht aus Seebeck Elementen (Seebeckschicht) und eine geeignete Schicht eines Phasenwechselspeichers (Latentwärmespeichers), der im natürlichen Einstrahlungsfall die Senke für die Wärmestrahlung darstellt.

In diesem Fall erzeugen die Nanoröhrenschicht und die Seebeckschicht elektrische Energie.

Ändert sich der natürliche Einstrahlungsfall dahingehend, dass eine natürliche Senke geringer ist als die des Phasenwechselspeichers, so kehrt sich die Wärmestrahlung um, und die Polarität an der Seebeckschicht ändert sich.

Die Vorrichtung ist derart gestaltet, dass durch die Überführung von elektrischer Energie von der Nanoröhrenschicht zur Seebeckschicht die Nanoröhrenschicht gekühlt und der Phasenwechselspeicher erhitzt wird. Dem System wird dabei keine Wärmeenergie entzogen. Es entsteht weiterhin eine Einlagerung der Gesamtenergie in das System.

Fällt die Strahlungsquelle aus, wird sich an der Nanoröhrenschicht in terrestrischer Umgebung Kondensat bilden, was bei zunehmender Kühlung jenseits des Triplepunktes des Wassers in Eis umgewandelt wird, und somit die Umgebung des Systems bei dieser Temperatur stabilisiert (Externer latenter Wärmespeicher). Erst wenn die Maximaltemperatur des inneren Phasenwechselspeichers erreicht ist, muss zum Schutz des Systems die Kühlung der Nanoröhrenschicht abgeschaltet werden, und die Seebeckschicht wird wieder elektrische Energie erzeugen.

In diesem Zustand steht einem externen elektrischen Verbraucher die elektrische Energie der Nanoröhrenschicht und der Seebeckschicht zur Verfügung. Nimmt der Verbraucher die elektrische Energie nicht ab, wird ein Teil des externen Latentwärmespeichers abgetragen. Dabei wird je nach Richtung des Wärmestroms auch Wärme in den inneren Phasenwechselspeicher geführt (Abklingvorgang).

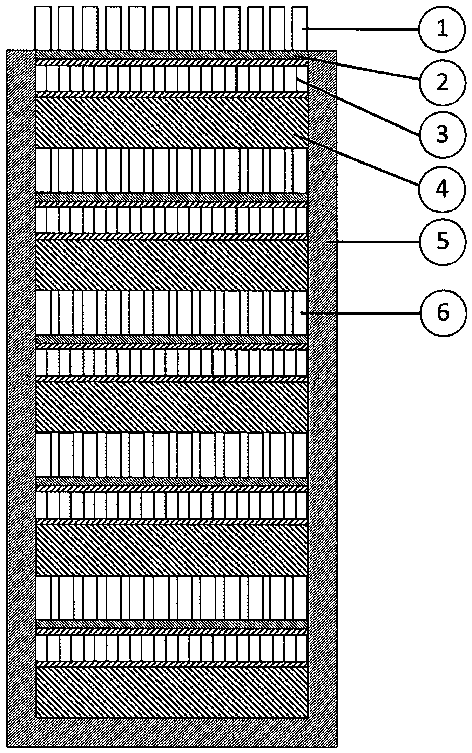

Bringt man wie in Abbildung 2 dargestellt mehrere dieser Zellkombinationen in einer fünfseitig thermisch und elektrisch isolierten Anordnung an und bestückt die einzelnen Zellen mit Phasenwechselspeichern unterschiedlicher Phasenumschlagtemperaturen, lässt sich so ein System aufbauen, das einem äußeren elektrischen Verbraucher eine konstante elektrische Leistung dauerhaft bereitstellen kann, und durch die inneren Verbraucher äußere Lastwechsel kompensiert. Die inneren Nanoröhrenschichten nehmen jeweils bei der inneren Umlagerung der Wärmeleistung die Aufgabe der elektrischen Generatoren wahr, da die Freisetzung von Elektronen in der Nanoröhrenschicht nicht von diskreten Wellenlängen abhängig ist.

Demzufolge lässt sich die Wirkungsweise der erfindungsgemäßen Vorrichtung wie folgt zusammenfassen: Kühlt oder erhitzt die Vorrichtung die Umgebung, so wandelt sie die der Umgebung entzogene Energie in elektrische Energie um. Steht kein elektrischer Verbraucher zur Verfügung, so speichert die Anlage diese Energie in Form von Wärmeenergie und stellt den inneren elektrischen Quellen eigene Verbraucher zur Verfügung, die diese Vorrichtung in ein thermisches Gleichgewicht bringen. Steht ein elektrischer Verbraucher zur Verfügung, so liefert die Anlage selbsttätig erneut elektrische Energie.

Ferner zeigt Abbildung 2 eine besondere Ausführung, bei der der Phasenwechselspeicher aus einem mechanisch steuerbaren Salzhydridspeicher besteht (Wärmekissen). Hiermit lässt sich der Prozess der elektrischen Energiegewinnung grundsätzlich starten und im Falle eines großen Speicherbedarfs wirkungsvoll bremsen, wenn kein externer elektrischer Bedarf besteht. Wird das System so konstruiert, dass der Salzhydridspeicher wechselbar ist, lässt sich die gespeicherte Energie relativ gefahrlos transportieren.

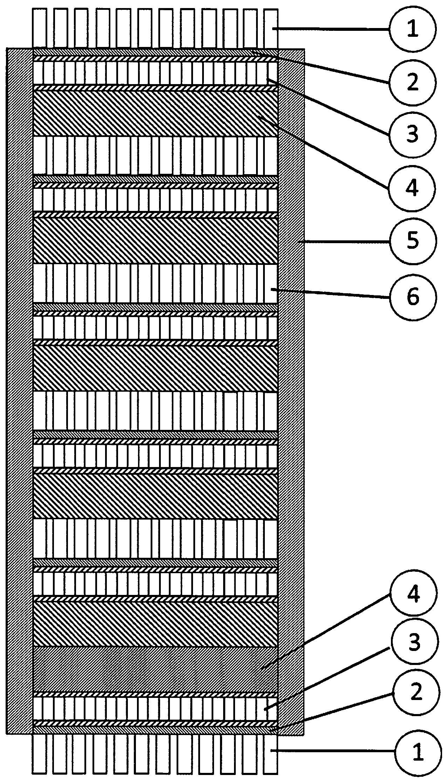

Abbildung 3 zeigt eine gegenüberliegend geöffnete Anordnung eines Zellstapels, wobei die erste bzw. letzte Zelle um 180° gedreht ist. Hieraus ergibt sich eine erhöhte Latentwärmekapazität in dem Bereich der sich berührenden Phasenwechselspeicher. Mit einem vorteilhaften Regelalgorithmus sind hiermit Raum bildende Ebenen geschaffen, deren Räume unterschiedliche klimatische Bedingungen aufweisen unter Auskopplung elektrischer Energie.

Idealerweise wird die gesamte solare Strahlung in elektrische Energie gewandelt, was voraussetzt, dass der Phasenwechselspeicher entweder genügend groß dimensioniert ist oder durch eine nachgeschaltete Thermogeneratorphasenwechselspeicher-Kombinationen die anfallende Wärme in Zeiten direkter solarer Einstrahlung an unterschiedlichen Phasenwechseltemperaturen gelagert wird.

Bei der Auslagerung der Wärmeenergien aus den Phasenspeichern produzieren somit die beteiligten Thermogeneratoren und, da es sich hierbei vorwiegend um Wärmestrahlung handelt, die Nanoröhrenschicht elektrische Energie.

Entgegen der herkömmlichen kristallinen Photovoltaik-Anlagen ermöglicht die erfindungsgemäße Nanoröhrenthermogenerator-Phasenwechselspeicher-Zelle erstmalig die Erzeugung elektrischer Energie ohne dabei auf die direkte Sonneneinstrahlung angewiesen zu sein. Zum einen kann mit der erfindungsgemäßen Anlage das gesamte Strahlungsspektrum genutzt werden - also auch der UV- und IR-Bereich. Zum anderen ermöglicht die Konstruktion eine kontinuierliche Stromerzeugung - auch über Nacht. Im Ergebnis wird eine Leistungssteigerung im Zusammenspiel der Komponenten auf das Fünfzigfache der bisher pro Fläche spezifisch erzeugten elektrischen Energie handelsüblicher PV Zellen erzielt. Anders ausgedrückt reduziert sich die Fläche, die gegenwärtig für ein KW/h erforderlich ist, von 7 - 9 m² auf 30 cm² bei voller Grundlastfähigkeit.

Das System ist nicht nur auf solare Einstrahlung angewiesen, sondern kann auch jedwede Wärmestrahlung in elektrische Energie wandeln und sich über den inneren Wärmetransfer aufladen.

### Legende zu den Abbildungen

**Abbildung 1****:** Modul eines Nanoröhrenthermogenerator-Phasenwechselspeichers
   - 1: Nanoröhrenschicht, bevorzugt Graphen
   - 2: Nanoröhrenträger, bevorzugt ein Siliziumträger mit Siliziumnitridschicht und seitlicher elektrischer Kontaktierung
   - 3: Thermogenerator
   - 4: Phasenwechselspeicher
   - 5: Thermoelektrische Isolierung
**Abbildung 2****:** Modul eines Nanoröhrenthermogenerator-Phasenwechselspeichers mit einem Phasenwechselspeicher aus einem mechanisch steuerbaren Salzhydridspeicher; einseitiger Zellstapel:
   - 1: Nanoröhrenschicht, bevorzugt Graphen
   - 2: Nanoröhrenträger, bevorzugt ein Siliziumträger mit Siliziumnitridschicht und seitlicher elektrischer Kontaktierung
   - 3: Thermogenerator
   - 4: Phasenwechselspeicher (Salzhydridspeicher)
   - 5: Thermoelektrische Isolierung (z.B. Dewargefäß)
   - 6: innere Nanoröhrenschicht, bevorzugt Graphen
**Abbildung 3****:** Modul eines Nanoröhrenthermogenerator-Phasenwechselspeichers mit einer gegenüberliegend geöffneten Anordnung; zweiseitiger Zellstapel
   - 1: Nanoröhrenschicht, bevorzugt Graphen
   - 2: Nanoröhrenträger, bevorzugt ein Siliziumträger mit Siliziumnitridschicht und seitlicher elektrischer Kontaktierung
   - 3: Thermogenerator
   - 4: Phasenwechselspeicher
   - 5: Thermoelektrische Isolierung (z.B. Dewargefäß)
   - 6: innere Nanoröhrenschicht, bevorzugt Graphen

## Patentansprüche

1. Anlage zur Erzeugung elektrischer Energie aus Strahlung, **gekennzeichnet durch** eine Nanoröhrenschicht (1) bestehend aus Graphen, die bei Auftreffen von Strahlung unabhängig von der Wellenlänge in jedem Strahlungsbereich freie Elektronen freisetzt, beschaltet mit einer Vorrichtung zur Ladungstrennung, wobei die Vorrichtung zur Ladungstrennung eine Diode ist, einem Nanoröhrenträger (2) mit einseitiger elektrischer Kontaktierung, einem Modul zur Temperaturstabilisierung (3), bestehend aus mindestens einem Seebeck-Element, einem jeweils nachgeordneten Latentwärmespeicher (4) und einer mehrseitig umfassenden Isolationsschicht (5).

2. Elektrische Anlage nach Anspruch 1, **dadurch gekennzeichnet, dass** der Nanoröhrenträger (2) aus einem Träger besteht, auf dem Graphen abgeschieden werden kann, bevorzugt einem Siliziumträger mit Siliziumnitridschicht.

3. Elektrische Anlage nach Anspruch 1-2, **dadurch gekennzeichnet, dass** die Nanoröhrenschicht (1) über eine externe elektrische Verschaltung gesteuert wird, die keine externe elektrische Quelle zur Erzeugung elektrischer Energie benötigt.

4. Elektrische Anlage nach Anspruch 1-3, **dadurch gekennzeichnet, dass** die erzeugte elektrische Energie zu einem Verbraucher ausgekoppelt wird.

5. Elektrische Anlage nach Anspruch 1-4, **dadurch gekennzeichnet, dass** die Seebeck-Elemente aus Halbleiterwerkstoffen gefertigt sind.

6. Elektrische Anlage nach Anspruch 1-5, **dadurch gekennzeichnet, dass** die Seebeck-Elemente jeweils mit einem Latentwärmespeicher (4) und einer Nanoröhrenschicht (1) verbunden sind.

7. Elektrische Anlage nach Anspruch 1-6, **dadurch gekennzeichnet, dass** der Latentwärmespeicher (4) als Salzhydridspeicher ausgeführt ist.

8. Elektrische Anlage nach Anspruch 1-7, **dadurch gekennzeichnet** das der Latentwärmespeicher (4) mechanisch wechselbar ist.

## Claims

1. System for generating electrical energy from radiation, **characterized by** a nanotube layer (1) consisting of graphene, which releases free electrons in any radiation range when radiation impinges on it, irrespective of the wavelength, wired with a device for charge separation, the device for charge separation being a diode, a nanotube carrier (2) with electrical contacting on one side, a module for temperature stabilization (3), consisting of at least one Seebeck element, a respective downstream latent heat store (4) and an insulating layer (5) comprising several sides.

2. Electrical installation according to claim 1, **characterized in that** the nanotube carrier (2) consists of a carrier on which graphene can be deposited, preferably a silicon carrier with a silicon nitride layer.

3. Electrical system according to claim 1 - 2, **characterized in that** the nanotube layer (1) is controlled via an external electrical circuit which does not require an external electrical source to generate electrical energy.

4. Electrical installation according to claim 1 - 3, **characterized in that** the generated electrical energy is decoupled to a consumer.

5. Electrical system according to claim 1 - 4, **characterized in that** the Seebeck elements are made of semiconductor materials.

6. Electrical system according to claim 1 - 5, **characterized in that** the Seebeck elements are each connected to a latent heat accumulator (4) and a nanotube layer (1).

7. Electrical system according to claim 1 - 6, **characterized in that** the latent heat accumulator (4) is designed as a salt hydride accumulator.

8. Electrical system according to claims 1 - 7, **characterized in that** the latent heat accumulator (4) is mechanically exchangeable.

## Revendications

1. Installation pour la génération d'énergie électrique à partir de rayonnement, **caractérisée par** une couche de nanotubes (1) composée en graphène qui libère des électrons libres dans chaque zone de rayonnement lors de l'impact du rayonnement, indépendamment de la longueur d'onde, câblée avec un dispositif pour la séparation de charges, le dispositif de séparation de charges étant une diode, un support de nanotubes (2) avec un contact électrique d'un côté, un module de stabilisation de température (3) composé d'au moins un élément Seebeck, un accumulateur de chaleur latente (4) respectivement en aval et une couche isolante (5) comprenant plusieurs côtés.

2. Installation électrique selon la revendication 1, **caractérisée en ce que** le support de nanotubes (2) est composé d'un support sur lequel du graphène peut être séparé, de préférence un support de silicium avec une couche de nitrure de silicium.

3. Installation électrique selon les revendications 1 et 2, **caractérisée en ce que** la couche de nanotubes (1) est commandée par une connexion électrique externe qui ne requiert aucune source électrique externe pour générer de l'énergie électrique.

4. Installation électrique selon les revendications 1 à 3, **caractérisée en ce que** l'énergie électrique générée vers un consommateur est découplée.

5. Installation électrique selon les revendications 1 à 4 **caractérisée en ce que** les éléments Seebeck sont produits en matériaux semi-conducteurs.

6. Installation électrique selon les revendications 1 à 5, **caractérisée en ce que** les éléments Seebeck sont respectivement connectés avec un accumulateur de chaleur latente (4) et une couche de nanotubes (1).

7. Installation électrique selon les revendications 1 à 6 **caractérisée en ce que** l'accumulateur de chaleur latente (4) revêt la forme d'un accumulateur à hydrure de sel.

8. Installation électrique selon les revendications 1 à 7 **caractérisée en ce que** l'accumulateur de chaleur latente (4) est mécaniquement remplaçable.
